# EUROPEAN PATENT APPLICATION

(11) **EP 1 432 023 A1**
(43) Date of publication of application: **23.06.2004**
(21) Application number: 02770176.2
(22) Date of filing: 29.08.2002
(51) Int. Cl.: H01L 21/768

(54) **SEMICONDUCTOR DEVICE AND PRODUCTION METHOD THEREFOR**

(30) Priority: 29.08.2001 JP 2001260181
(71) Applicant: Tokyo Electron Limited, Tokyo 107-8481 (JP)
(72) Inventor: MURAKAWA, Shigemi, c/o Tokyo Electron Limited, Tokyo 107-8481 (JP); MATSUSHITA, Minoru, c/o Tokyo Electron Limited, Tokyo 107-8481 (JP); OZAKI, Shigenori, Amagasaki-shi, Hyogo 660-0891 (JP)
(74) Representative: Liesegang, Eva
(86) International application number: PCT/JP2002/008737
(87) International publication number: WO 2003/019650

(57) **Abstract**

A hole which is to be a part of an interconnection (wiring) hole (21) is formed penetrating through a second insulating layer (13) and a third insulating layer (14) made of porous silicon oxide film, by etching. Further, a second groove (23) is formed on the third insulating layer (14) using a second stopper film (20), by etching. Further, direct nitriding of a silicon oxide film applying an RLSA plasma processing deice is carried out on the side wall of the interconnection hole (21) and the second groove (23), and a barrier layer (25) made of SiN film is formed. Here, the second stopper film (20) and the bazrier layer (25) are formed by the same direct nitriding.

## Description

### Technical Field

The present invention relates to a semiconductor device with a high reliability, and a manufacturing method thereof.

### Background Art

Speeding up of signal processing is necessary, for achieving high efficiency of large-scale integration circuits (LSIs). Speeding up of signal processing can be carried out by miniaturization of circuits and reducing signal delay on interconnection. In recent years, miniaturizing has progressed, and designing rule of LSI has reached to 0.13 micrometers, and reduction in signal delay on interconnection is especially important in this kind of LSI.

Reduction in a resistance of interconnections is the effective means for reducing the above signal delay on interconnections. To reduce in a resistance of interconnection, copper, which has a high electro-migration tolerance and has a low resistance, is used instead of aluminum which has been conventionally used. Because processing of the conventional etching is difficult in a case where copper interconnection (wiring) is used, the so called Dual Damascene method is used for realizing multi-layered interconnection, without etching the copper.

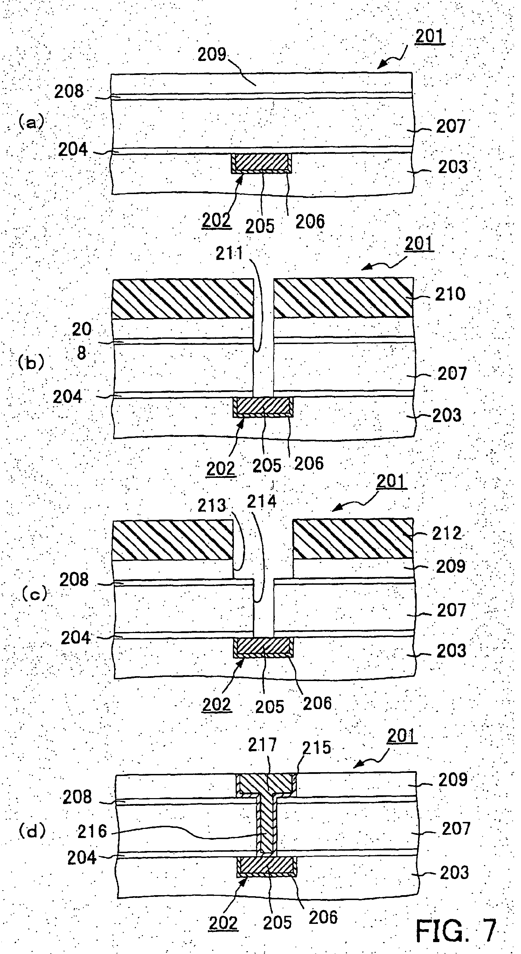

A process of manufacturing a semiconductor device 201, which comprises a multi-layered interconnection layer, using the Dual Damascene method will be described with reference to FIGS. 7 (a) to (d). First, a cap layer 204 made of silicon nitride, etc., is formed on a first insulating layer 203 made of silicon oxide, etc., where an interconnection (wiring) layer 202 is embedded. The interconnection layer 202 surrounds a conductor layer 205 made of copper, and a conductor layer 205, and comprises a barrier layer 206 made of tantalum nitride, etc. Next, a second insulating layer 207 made of silicon oxide, etc., is formed on the cap layer 204. Further, a stopper film 208 made of silicon nitride, etc., is formed on the second insulating layer 207, and a third insulating layer 209 made of silicon oxide, etc., is stacked thereon. By this, result abstructures shown in FIG. 7 (a) can be obtained.

Sequentially, as shown in FIG. 7 (b), a resist pattern 210 is formed on the third insulating layer 209, and a hole 211 having the conductor layer 205 as bottom, by etching, is formed. At this time, etching is carried out on the condition that the second and third insulating films 207 and 209, the stopper film 208, and the cap layer 204 are etched. After etching, the resist pattern 210 is removed by ashing, etc.

Sequentially, as shown in FIG. 7 (c), a resists pattern 212 is formed on the third insulating film 209. And an interconnection groove 213 which overlaps with the hole 211 and has the stopper film 208 as the bottom, is formed on the third insulating film 209. By this, the interconnection groove 213, and the interconnection hole 214 that connects the interconnection groove 213 and the interconnection layer 202 is formed. Here, etching is carried out on the condition that the third insulating film 209 is etched, but the stopper film 208 is not. Therefore, etching is stopped at the stopper film 208. After etching, the resist pattern 212 is removed by ashing, etc.

Sequentially, a barrier layer 215 made of tantalum nitride, etc., by CVD, etc., to the inner wall of the interconnection groove 213 and the interconnection hole 214, is formed. Further, after the interior of the interconnection groove 213 and the interconnection hole 214 are embedded by the plating method, additional copper is removed by CMP. By the above process, as shown in FIG. 7 (d), a plug layer 216, and a conductive layer 217 connected to the conductive layer 205 by the plug layer 216 are formed.

In the semiconductor device 201 formed by the above Dual Damascene method, the barrier layer 215 is provided to prevent diffusion of copper, which is interconnection material. Because copper is highly diffusive, and is inclined to deteriorate the characteristic of the semiconductor, the barrier layer 215 is a necessity in forming interconnection layers made of copper. Especially, in recent years, because the porous films that are preferably used for the reason that the dielectric constant is low, has many holes in the interior, copper atoms are likely to penetrate (diffuse).

The barrier layer 215 is generally structured singularly by metal material such as titanium nitride, and tantalum nitride, etc., or by being laminated, and is formed by CVD, etc. However, accompanying the development of miniaturization, if an interconnection hole 214 such as shown in FIG. 7(c) is further miniaturized, it becomes difficult to form a highly reliable barrier layer 215 to the entire inner wall of the interconnection hole 214.

Namely, for example, if the interconnection hole 214 is extremely minute, infilteration of precursors (organic metal, etc.) of the barrier layer 215 is physically prevented, and deposition speed in the lower part becomes slower than the upper part of the interconnection hole 214. By this a barrier layer 215 with enough thickness is not formed in the lower part of the interconnection hole 214, and barrier characteristic deteriorates. Further, if the barrier layer 215 is uneven, void becomes likely to occur in the latter copper embedding process.

At this time, in a case where porous insulating films are used as interlayer dielectric films 207 and 209, precursors infilterate through the hole in the insulation film, when forming the barrier-layer 215 by CVD. These react with etching gas at the time of etching, and leads to deterioration of the insulating film.

Accompanying miniaturization, the thickness of the barrier layer 215 becomes thinner, and the adhesiveness to the surface of the interconnection groove 213 and the interconnection hole 214 is deteriorated. By this, peeling off, etc., of the barrier layer 215 becomes likely to occur, and reliability of the barrier layer 215 and the semiconductor device 201 degrades. In this way, it is difficult to form a highly reliable barrier layer at the inner wall of a highly miniaturized (with a high aspect ratio) groove or hole.

On the other hand, as described above, in the Dual Damascene method, the stopper film 208 of etching is used. As shown in FIG. 7 (d), the stopper film 208 forms the bottom part of the interconnection groove 213. Accompanying the progress of miniaturization, thinning of the stopper film 208 is also being sought. Therefore, in the same way as the above barrier layer 215, in a case where a thin film stopper film 208 formed by CVD, etc., is used, adhesiveness with the second insulating film 207 deteriorates, and peeling off becomes likely to occur. In the case where the stopper film 208 is peeled off, etc., the barrier layer 215 stacked thereon becomes uneven, and lowly reliable.

In this way, it is hard to form highly reliable barrier layers and stopper films by conventional PVD or CVD, on the inner wall of the miniaturized interconnection grooves and interconnection holes, and there was a risk of deteriorating the reliability of the semiconductor device, by the diffusion, etc., of interconnection material.

### Disclosure of Invention

In consideration of the above, an object of the present invention is to provide a highly reliable semiconductor device and manufacturing method thereof.

Another object of the present invention is to provide a semiconductor device which comprises a highly reliable barrier layer, and manufacturing method thereof.

Still another object of the present invention is to provide a semiconductor device which comprises a highly reliable stopper film, and manufacturing method thereof.

To achieve the above objects, a manufacturing method of a semiconductor device according to a first aspect is characterized by comprising:
a step of forming insulating layers that are structured by silicon as the main component, and comprises a groove at one side, and a hole that penetrates from the bottom part of the groove to the other side;
a barrier layer forming step of exposing the surface of the inner wall of the groove and the hole to the plasma of gas including nitrogen, and forming a barrier layer that is structured by silicon nitride film, on the surface region of the inner wall of the groove and the hole;
a step of embedding an interconnection layer made of conductive material, to the inner side of the groove and the hole through the barrier layer.

In the above structure, a barrier layer made of silicon nitride film is formed at the inner wall of an interconnection groove and an interconnection hole, where interconnection material (especially copper) is embedded. Silicon nitride film that constitutes the barrier layer is formed by reforming the surface region of the insulating layers made of a film including silicon, by plasma of nitrogen gas. In this way, by directly reforming the surface of the insulating layers, a thin barrier layer can be formed with a high reliability at the inner wall of a groove and hole, which is minute and has a high aspect ratio. By this, a highly reliable semiconductor device where diffusion of interconnection material is reduced, can be provided.

In the above structure, it is preferable that the barrier layer forming step comprises a step of nitriding the surface region of the groove and the hole by exposing the surface of the inner wall of the groove and the hole to the plasma of gas including nitrogen. In this way, by forming the barrier layer by direct nitriding of the insulating layers, a thin barrier layer with little peeling off, etc., can be formed.

In the above structure, it is preferable that the plasma of gas including nitrogen is generated by irradiating microwave from a plane antenna that comprises a plurality of slits to gas including nitrogen. By this, a thin barrier layer can be formed, reducing plasma damage provided to other film surfaces.

In the above structure, the insulating layers may be structured by porous dielectric film. In the forming of the barrier layer, metal precursor such as organic metal, etc., are not used, and even in a case where a porous dielectric film is used to the insulating layers, metal precursors, etc., do not enter the hole in the insulating layers. By this, deterioration of insulating layers occurred by reaction, etc., of metal precursors and etching gas in the hole is prevented, and a highly reliable semiconductor device can be obtained.

To achieve the above objects, a manufacturing method of a semiconductor device according to a second aspect is characterized by comprising:
a step of forming a first insulating layer structured by silicon as the main component,
a step of exposing the surface of the insulating layer to the plasma of gas including nitrogen, and forming a stopper film that is structured by silicon nitride film, on the surface region of the first insulating layer;
a step of forming a second insulating layer on the stopper film;
a step of forming a hole that penetrates the first insulating layer and the second insulating layer;
a step of forming a hole or a groove that overlaps with the hole in said second insulating layer, as an etching stopper of the stopper film.

According to the above structure, the stopper film made of silicon nitride film is formed by surface modification by plasma. The formed stopper film is a film with little plasma damage on the surface and of high quality. By this, the stopper film that comprises the bottom part of the interconnection groove can be formed with at high reliability.

In the above structure, it is preferable that the step of forming the stopper film comprises a step of nitriding the surface region of the first insulating layer by exposing the surface of the first insulating layer to the plasma of gas including nitrogen. In this way, by forming the stopper film by direct nitriding of the insulating films, a thin stopper film with little peeling off, can be formed controlling surface damage.

In the above structure, the first and second insulating layers may be structured by porous dielectric film.

In the above structure, copper may be used as the main component, as the conductive material. Namely, the silicon nitride film has barrier characteristics towards copper, and functions effectively as the barrier layer.

In the above structure, gas including hydrogen may be further used as the above gas. By this, at the same time as the forming of the silicon nitride film, hydrogen can be combined with the dangling bond of silicon that exists at the surface region of the insulating layers, so that the film can be stabilized.

In the above structure, it is preferable that the forming of the barrier layer is carried out at room temperature to 600°C. By carrying out processing at a relatively low temperature, diffusion of impurities can be preverited, and deterioration of device characteristic can be prevented.

In the above structure, the barrier layer may be formed in a thickness of 1nm to 20nm. Also, the stopper film may be formed in a thickness of 1nm to 20nm.

To achieve the above objects, a semiconductor device according to a third aspect of the present invention is characterized by comprising:
insulating layers that are structured by silicon as the main component, and comprises a groove at one side, and a hole that penetrates from the bottom part of the groove to the other side;
an interconnection layer, which is embedded in the groove and the hole, and is made of conductive material; and
a barrier layer which is provided at the interface with the insulating layers and the interconnection layer, and which prevents diffusion of the conductive material, to the insulating layers.

According to the above structure, by applying silicon nitride film as the barrier layer, substantially, metal precursors do not enter the hole in the insulating layers at the time of forming the barrier film, as in the case of forming a barrier film including metal. Therefore, destruction and deterioration of insulating layers after processes of etching, etc., can be prevented, and a highly reliable semiconductor device can be obtained.

To achieve the above objects, a semiconductor device according to a fourth aspect of the present invention is characterized by comprising:
insulating layers that are structured by silicon as the main component, and comprises a groove at one side, and a hole that penetrates from the bottom part of the groove to the other side;
an interconnection layer, which is embedded in the groove and the hole, and is made of conductive material,
a barrier layer which is provided at the interface with the insulating layers and the interconnection layer, and which prevents diffusion of the conductive material, to the insulating layers; wherein
the barrier layer is formed by exposing the surface of the insulating layers to the plasma generated by irradiating microwave from a plane antenna that comprises a plurality of slits to gas that includes nitrogen, and forming silicon nitride film on the surface region of the insulating layers.

In the above structure, a barrier layer made of silicon nitride film is formed at the inner wall of an interconnection groove and an interconnection hole, where interconnection material (especially copper) is embedded. A silicon nitride film that constitutes the barrier layer is formed in the surface region of the insulating layers made of a film including silicon by microwave plasma applying radial line slot antenna (RLSA). In this way, by applying RLSA plasma, a thin barrier layer can be formed with a high reliability at the inner wall of a groove and hole, which is minute and has a high aspect ratio. By this, a highly reliable semiconductor device where diffusion of interconnection material is reduced can be provided.

To achieve the above objects, a semiconductor device according to a fifth aspect of the present invention is characterized by comprising:
a first insulating layer which comprises a hole and which is structured by silicon as the main component;
a stopper film provided on the first insulating layer, and comprises an opening that overlaps with the hole;
a second insulating layer which is provided on the stopper film, and comprises a hole or groove that overlaps with the opening, and has a larger diameter than the opening; wherein
the stopper film is formed by exposing one surface of the first insulating layer to the plasma of gas including nitrogen, which is generated by irradiating microwave from a plane antenna comprising a plurality of slits to the gas including nitrogen.

According to the above structure, the stopper film made of silicon nitride film is formed by RLSA plasma. The stopper film formed by RLSA plasma is a high quality film with little damage on the surface. By this, the stopper film that structures the bottom part of the interconnection groove can be formed with high reliability.

### Brief Description of Drawings

FIG. 1 is a diagram showing a structure of a semiconductor device according to the embodiment of the present invention.
FIG. 2 is a diagram showing a structure of a plasma processing device according to the embodiment of the present invention.
FIG. 3 is diagram showing a structure of RLSA according to the embodiment of the present invention.
FIG. 4 is a diagram showing a manufacturing process of a semiconductor device according to the embodiment of the present invention.
FIG. 5 is a diagram showing a manufacturing process of a semiconductor device according to the embodiment of the present invention.
FIG. 6 is a diagram showing a manufacturing process of a semiconductor device according to the embodiment of the present invention.
FIG. 7 is a diagram showing a process of the Dual-Damascene method.

### Best Mode for Carrying Out the Invention

A semiconductor device according to the present embodiment will be described with reference to the drawings. The semiconductor device of the present embodiment comprises a transistor that is provided on a semiconductor substrate, elements such as a memory, etc., and a multi-layered interconnection (wiring) layer connected thereto.

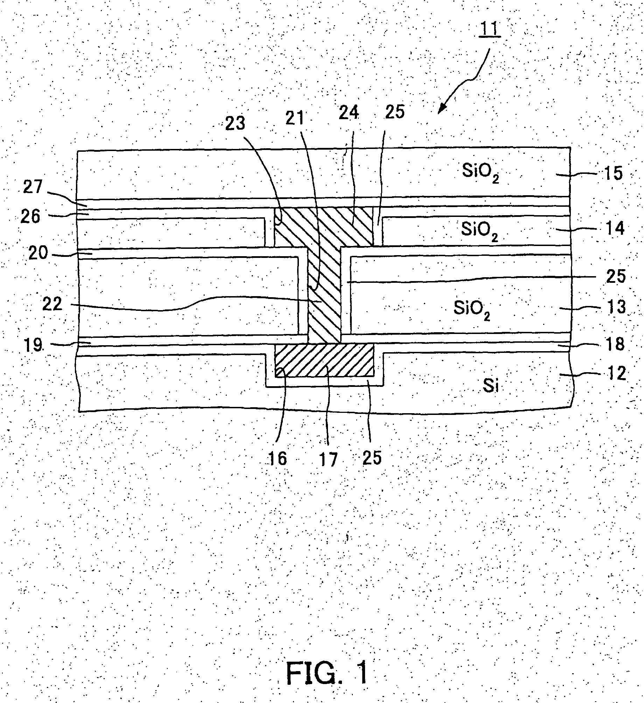

FIG. 1 is a partial cross section view showing multi-layered interconnection (wiring) at the top layer of a semiconductor device 11 of the present embodiment. As shown in FIG. 1, the semiconductor device 11 comprises a first insulating layer 12, a second insulating layer 13, a third insulating layer 14, and a passivation film 15.

The first insulating layer 12 comprises a low dielectric constant silicon oxide (SiO₂) film, which is formed by having a predetermined porous density. The first insulating layer 12 comprises a first groove 16, and a first interconnection (wiring) layer 17 made of copper, is embedded in the first groove 16. A film 18 made of silicon nitride (SiN) is provided on the surface of the first insulating layer 12.

The second insulating layer 13 is placed on the first insulating layer 12. The second insulating layer 13 comprises a porous low dielectric constant silicon oxide film. The second insulating layer 13 comprises a first and second stopper film 19 and 20 made of SiN, at the surface that contacts the first insulating layer 12 and the surface opposite thereof. The first and second stopper films 19 and 20 are provided at a thickness of, for example, 10 to 30nm.

An interconnection hole 21 is provided penetrating through the second insulating layer 13, which is upwards of the first groove 16. A plug layer 22 made of copper is embedded in the interconnection bole 21.

The third insulating layer 14 is provided on the second insulating layer 13. The third insulating layer 14 comprises a porous low dielectric constant silicon oxide film. Asecond groove 23 is provided penetrating through the third insulating layer 14, which is on top of the interconnection hole 21. A second interconnection layer 24 made of copper is embedded in the second groove 23.

In this way, the multi-layered interconnection layer is formed by the first interconnection layer 17, the plug layer 22, and the second interconnection layer 24. In the inner wall of the first groove 16, the interconnection hole 21, and the second groove 23, a barrier layer 25 is formed. The barrier layer 25 comprises SiN, and is formed in a thickness of, for example, 5 to 10nm. The barrier layer 25 is provided to prevent diffusion of copper, which is the material of interconnection (wiring).

Here, the first and second stopper films 19, 20 and the barrier layer 25, which are made of SiN, are formed by direct nitriding of the silicon oxide film using an RLSA type plasma processing device, which will be later described.

An SiN film 26 is provided on the surface of the third insulating layer 14. The passivaition film 15 is stacked on the third insulating layer 14, through an SiN film 27. The passivation film 15 comprises silicon oxide, and FSG, etc., and functions as an overcoat of the semiconductor device 11. The SiN layer 27 that separates the passivation film 15 and the third insualting layer 14, prevents diffusion of copper which is the material of interconnection.

A plasma processing device used for forming the barrier layer 25 of the above semiconductor device 11 will be described with reference to the drawings. The plasma processing device used for forming the barrier layer 25 is an RLSA (Radial Line Slot Antenna) type. The plasma processing device generates plasma of the gas to be processed using microwave energy, and modifies the surface of the target to be processed (material including silicon) by the plasma.

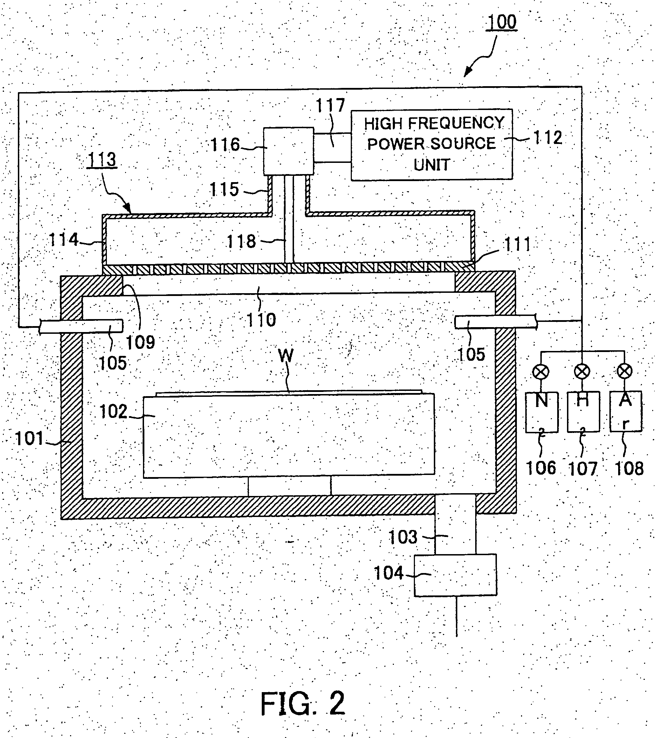

FIG. 2 shows a cross-sectional structure of a plasma processing device 100. As shown in FIG. 2, the plasma processing device 100 comprises an approximately cylindrical chamber 101. The chamber 101 comprises Aluminum, etc.

In the center of the chamber 101, a placing base 102 for a semiconductor wafer (hereinafter referred to as wafer W), which is a target to be processed, is placed. A temperature controller, which is not shown, is embedded in the placing base 102, and the wafer W is heated to a predetermined temperature, for example, room temperature to 600°C, by the temperature controller.

In the bottom part of the chamber 101, one end of an exhaust pipe 103 is connected, and the other end is, connected to an exhaust device 104, such as a vacuum pump, etc. The interior of the chamber 101 is set to a predetermined pressure, for example of 4.0Pa to 0.13kPa (30mTorr to 1 Torr), by the exhaust device 104, etc.

Gas supply lines 105 are provided on the upper side of the chamber 101. The gas supply lines 105 are connected to Nitrogen (N₂) gas source 106, Hydrogen gas source (H₂), and Argon (Ar) gas source 108. The gas supply lines 105 are placed evenly spaced apart, for example, in 16 places, in a circumferential direction of the side wall of the chamber 101. By being placed in this way, the gas supplied from the gas supply lines 105 is evenly provided upwards of the wafer W on a placing base 102.

An opening 109 is provided at the upper part of the chamber 101. A window 110 is provided in the inner side of the opening 109. The window 110 comprises transmission material, inorganic material such as quartz, SiO₂ glass, Si₃N₄, NaCl, KCl, LiF, CaF₂, BaF₂, Al₂O₃, AlN, and MgO, and a film and a sheet of organic material, such as polyethylene, polyester, polycarbonate, celluloseacetate, polypropylene, polyvinylchloride, polyvinylidenechloride, polystyrene, polyamide, and polyimide.

For example, a radial line slot antenna (hereinafter referred to as RLSA) 111 is provided on the window 110. A waveguide 113 connected to a high frequency power source unit 112 is provided on the RLSA 111. The waveguide 113 comprises a planiform circular waveguide duct (tube) 114, which the bottom end thereof is connected to the RLSA 111, a cylindrical waveguide duct 115, which one end thereof is connected to the upper surface of the circular waveguide duct 114, a coaxial waveguide modulation 116, which is connected to the upper surface of the cylindrical waveguide duct (tube) 115, and a rectangular waveguide duct (tube) 117, which one end thereof is connected perpendicular to the side surface of the coaxial waveguide modulation 116, and the other end thereof is connected to to the high frequency power source unit 112. The RLSA 111 and the waveguide 113 are formed by copper plates.

In the interior of the circular waveguide duct 114, a coaxial waveguide duct (tube) 118 is placed. The coaxial waveguide duct 118 is made of axis material, which is made of conducting material, and one end thereof is connected to approximately the center of the upper surface of the RLSA 111, and the other end thereof is connected to the upper surface of the circular waveguide duct 114, on the same axis.

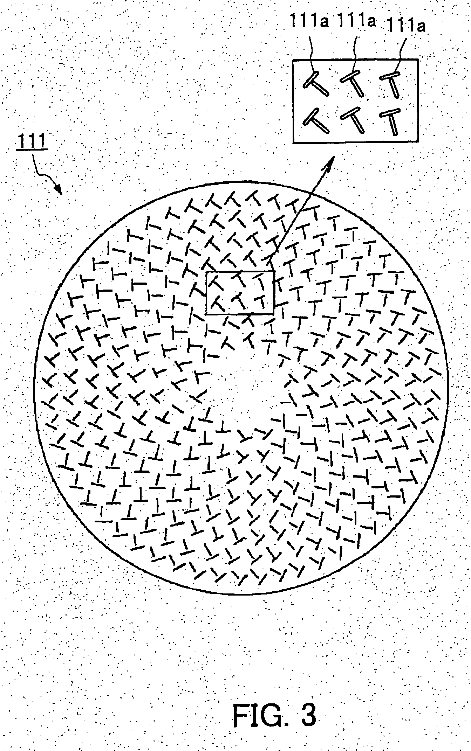

FIG. 3 shows a plane view of the RLSA 111. As shown in FIG. 3, the RLSA 111 comprises on the surface, a plurality of slots 111a, 111a, ... which are provided concentrically. Each slot 111a is an approximately rectangle through hole, and is arranged so that the adjacent slots 111a intersect with each other, to form an approximate alphabet T. The length and arrangement interval of the slots 111a are determined according to the wavelength of the radio-frequency wave generated by the high frequency power source unit 112.

The high frequency power source unit 112 generates a microwave of, for example, 2.45GHz, at an electric power of for eiample 500W to 5kW. The microwave generated from the high frequency power source unit 112 is transmitted through the rectangular waveguide duct 117 in a rectangular mode. Furthermore, the microwave is converted to a circular mode from the rectangular mode, in the coaxial waveguide modulation 116, and transferred to the cylindrical waveguide duct 115 in the circular mode. The microwave is further transferred in a state, extended in the circular waveguide duct 114, and is emitted by the slots 111a of the RLSA 111. The emitted microwave is supplied to the chamber 101, transmitting the window 110.

The interior of the chamber 101 is set at a predetermined vacuum pressure, and mixed gas of Ar, N₂, and H₂ is supplied to the interior of the chamber through a gas supply lines 105, at for example, Ar/ N₂/ H₂/ = 10: 1: 1. High frequency radio wave energy is transmitted to the mixed gas in the chamber 101, and high frequency radio wave plasma is generated. At this time, because the microwave is emitted from the many slots 111a of the RLSA 111, a high density plasma is generated.

Direct nitriding the surface of the wafer W is carried out by the generated high density plasma. Namely, nitrogen (N) radical in the generated plasma, acts on the surface of the silicon oxide film (SiO₂ film), which is formed on the wafer, and cuts the bond of Si and O and replaces the O to N. In this way, a few nm of the surface of the silicon oxide film is modified to SiN. At this time, the temperature of the wafer W is room temperature to 600°C, and the pressure in the chamber 101 is 4.0 Pa to 0.13kPa.

At this time, Ar in the mixed gas, works as diluted gas, and improves controllability of the reaction. The H radical generated from H₂ bonds with the dangling bond of Si, and stabilizes the SiN film formed by modifying, and improves the film quality.

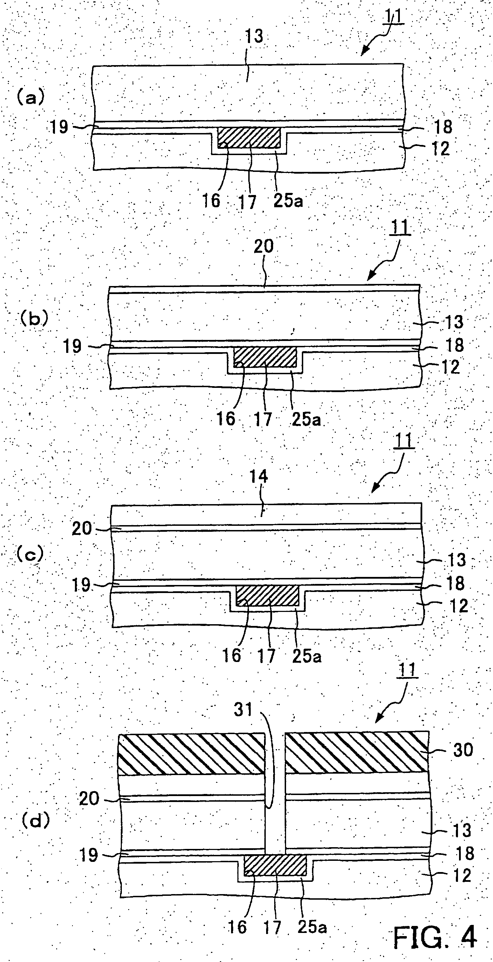

Manufacturing method of the above described semiconductor device 11 will be described with reference to the drawings. In the present embodiment, a semiconductor device 11 comprising a barrier layer 25 is manufactured by the Dual-Damascene method. FIGS. 4 (a) to (d), 5 (e) to (g) and 6 (h) shows the forming process of the interconnection layer of the semiconductor device 11.

First, a first insulating layer 12, comprising a first groove 16 in which a first interconnection layer 17 made of copper has been embedded, is prepared. The first insulating layer 12 is made of silicon oxide and is provided on the substrate of the semiconductor. In the circumference of the first groove 16, a barrier layer 25 made of SiN is provided, and on the surface of the first insulating layer 12, an insulating film made of SiN is formed. The first groove 16, and the barrier layer 25a, etc., are formed by the latter described Dual-Damascene method.

Next, as shown in FIG. 4 (a), a first stopper film 19 made of SiN is formed on the first insulating layer 12 by the CVD method, etc. Furthermore, a second insulating layer 13 made of silicon oxide is formed on the first stopper film 19 by the CVD method, etc. In this case, the thickness of the second insulating layer 13 is set so that it is the height of the interconnection hole 21.

Sequentially, as shown in FIG. 4 (b), nitriding is carried out by using an RLSA type plasma processing device 100, and a second stopper film 20 made of SiN is formed on the surface of the second insulating layer 13. Furthermore, as shown in FIG. 4 (c), a third insulating layer 14 made of silicon oxide is formed on the second stopper film 20. In this case, the thickness of the third insulating layer 14 is set so that it is the same height as the second groove 23.

Then, as shown in FIG. 4 (d), a resist pattern 30 is formed on the third insulating layer 14, and anisotropic etching is carried out on the condition that etching of the first and second stopper films 19 and 20, and the third insulating layer 14 are carried out at approximately the same speed. The etching can be carried out by using for example, mixed gas of CF₄ and O₂. By etching the resist pattern 30, the hole 31 that structures the interconnection hole 21 is formed.

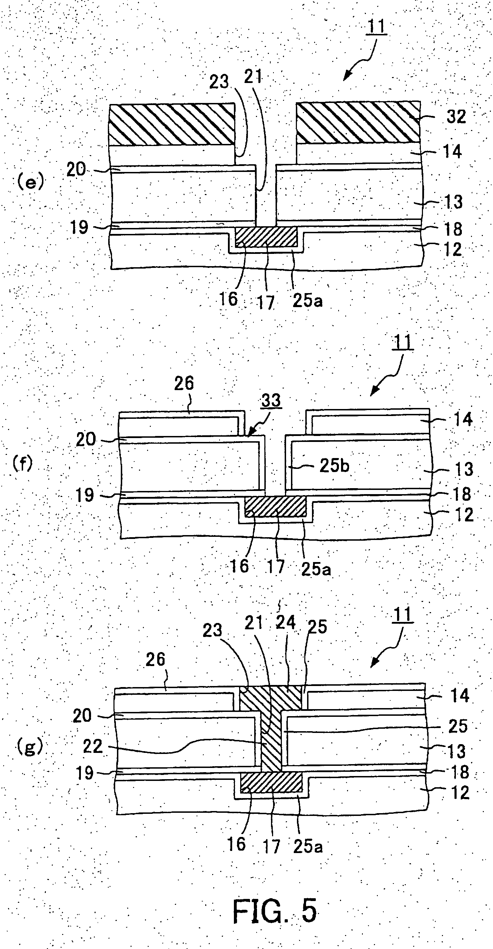

After the resist pattern 30 is removed by ashing, etc., as shown in FIG. 5 (e), a resist patter 32 is formed on the third insulating layer 14, and the anisotropic etching is carried out on the condition that third insulating layer 14 is etched, but the second stopper film 20 is not. The above etching can be carried out by using for example, mixed gas of C₄F₈ and CO. By the etching using the resist pattern 32, the second groove 23 is formed.

After the resist pattern 32 is removed by ashing, etc., as shown in FIG. 5 (f), nitrding of the entire surface, including the side walls of the interconnection hole 21 and the second groove 23 is carried out. Nitriding is carried out using the above described RLSA type plasma processing device 100, and a SiN film 33 is formed thinly, on the entire surface of the silicon oxide film. The SiN film 33 formed on inner walls of the interconnection hole 21 and the second groove 23 constitutes the barrier layer 25b and the SiN layer 26 for preventing diffusion of the interconnection material.

Sequentially, plating of copper is carried, after a seed layer made of copper is thinly formed by PVD, etc. After the interior of the interconnection hole 21 and the groove 23 is completely embedded by plating copper, an unnecessary metal film at the top surface is removed by CMP (Chemical Mechanical Polishing). By this, as shown in FIG. 5 (g), a double layer interconnect, where the first interconnection layer 17 and the second interconnection layer 24 are connected by the plug layer 22, is formed.

By repeating the above process predetermined times, a multi-layered interconnection (wiring) layer with two or more layers can be formed.

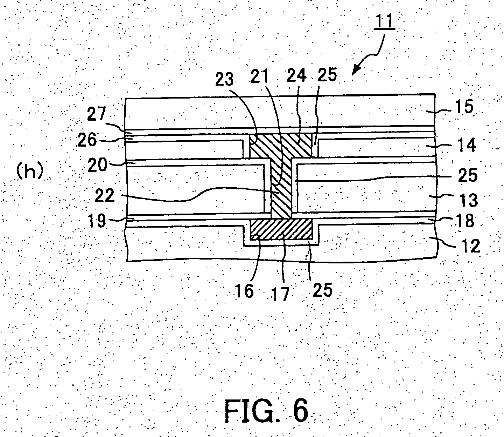

Finally, an SiN film, which prevents diffusion of copper, is formed on the surface of the semiconductor device 11 by CVD, etc. Then, as shown in FIG. 6 (h), a passivation film 15 made of SiO₂ and FSG, etc., is formed on the SiN film by CVD, etc. Overcoat such as SiN film, etc., may be further formed on the passivation film 15. In this way, passivation layer is formed on the multi-layered interconnection layer, and the manufacturing process of the semiconductor device 11 is completed.

As described above, in the semiconductor device 11 of the above embodiment, the barrier layer 25 that controls the diffusion of interconnection material is formed by direct nitriding of the insulating layer, using the RLSA type plasma processing device 100. By this, the barrier layer 25, which is thin and is hard to be peeled off is formed on the side wall of minute interconnection grooves 16, 23, and interconnection hole 21. Furthermore, because the barrier layer 25 is formed by direct nitriding of the insulating layer, blockage, etc., of the grooves by the formed film does not occur, and the barrier layer 25 can be formed in grooves with a high aspect ratio, without degrading the embedded characteristic.

In the same way, first and second stopper films 19 and 20, which are etching stopper films, are formed using the RLSA type plasma processing device 100. By this, stopper films, which are thin and hard to be peeled off, can be formed in the interlayer dielectric film.

By forming the barrier layer 25, first and second stopper films 19 and 20 by directly nitriding silicon films using the RLSA type plasma processing device 100, a highly reliable semiconductor device 11 can be obtained.

In the RLSA type plasma processing device 100, a nitriding process is carried out at relatively low temperature of room temperature to 600°C. Therefore, the electron temperature of the activated species in the generated plasma is approximately 1.5eV, and low. By this, forming of the barrier layer 25 and stopper films 19, 20 can be carried out, controlling the damage to the surface of the film, and preventing degradation of element characteristic due to difference diffusion, etc., of impurities in the element. Therefore, a highly reliable semiconductor device 11, which is prevented degradation of the element characteristic, can be formed.

Furthermore, the barrier layer 25 is structured by SiN, and not metal materials such as, tantalum nitride, or titanium nitride, etc. By this, substantially, there is no infilteration of metal precursor (organic metal, etc.) to the porous silicon oxide films 13 and 14, and reaction with the etching residue (fluorine, etc.), which is infilterated to the interior of the insulating film at the time of etching, can be prevented. By this, destruction of the barrier layer 25, and deterioration of the low dielectric constant film is prevented, and a higher reliability of the semiconductor device 11 can be obtained.

The present invention is not limited to the above embodiment, and various modifications and applications are possible. Below, an applicable modification mode of the above embodiment will be described.

In the above embodiment, the RLSA 111 and the waveguide 113 are structured by a copper plate. Here, materials such as Al, Cu, and Ag/Cu coated stainless steel, which have a high electric conductivity, can be preferably used as the material which structures the RLSA 111 and the waveguide 113 for controlling propagation loss of microwave.

The direction of the feed port to the circular waveguide 113 used in the present invention, can be a direction of feeding the microwave parallel to the H-plane, such as H-plane T-branch or tangent, or a direction of feeding the microwave orthogonal to the H-plane, such as E-plane T-branch, as long as microwave is effectively fed to the microwave propagation space in the circular waveguide 113. The slot interval of the microwave direction is most appropriate at 1/2 or 1/4 the wavelength in the duct.

In the above embodiment, high density plasma is generated using a microwave having a wavelength of 2.45GHz. However, it is not limited to this, and microwave frequency can be arbitrarily selected from the range of 0.8GHz to 20 GHz.

In the above embodiment, copper is used as material that structures the interconnection. However it is not limited to copper, and metal such as Aluminum or alloyed metal thereof may be used. Especially, as a plug, Tungsten, etc., that is a refractory metal may be used.

In the above embodiment, the first, second and third insulating layers 12, 13 and 14, are structured by low dielectric constant silicon oxide films that have a predetermined porous density. However, it is not limited to this, in the present invention, any kind of insulating film can be used as long as the film having silicon as the main component, and especially having a low dielectric constant. For example, in the present invention, a silicon film can be applied to, such as FSG (Fluorinated Silicate Glass), an SiC film, an SiCN film, or an SiOCH film, etc.

In the above embodiment, mixed gas of N₂, H₂, and Ar is used for directly nitriding the silicon oxide film. However, other gas may be used for nitriding. For example nitrogen included gas such as NH₃, N₂O, NO, NO₂, etc., can be used instead of N₂, and rare gas such as Ne, Xe, and Kr, etc., can be used instead of Ar. However, because the energy of the activated Ar prevents damage of the film surface, and makes possible activation of silicon (Si), the energy is suitable and preferable.

The mixing ratio of the above mixed gas is not limited to the above (Ar/N₂/H₂ = 10: 1: 1), and the abundance ratio of N₂ and H₂ can be changed in the range of for example, 0.05 to 5. Furthermore, reaction conditions such as wafer temperature and reaction pressure, etc., are not limited to the above, and may be of any kind as long as a high quality SiN film can be formed.

In the above semiconductor device 11, the first and second stopper films 19 and 20 may be formed by CVD, or PVD, etc., instead of the RLSA type plasma processing device 100. In this case, the stopper films 19 and 20 may be formed SiC, or SiCN, etc., besides SiN. However, from the point of productivity, it is preferable to form the barrier layer 25 and first and second stopper films 19 and 20 by the RLSA type plasma processing device 100.

The RLSA type plasma processing device 100 used in the present invention may be used as a cluster system, combining a CVD device, an etching device, and a sputtering device for forming seed layers.

As described above according to the present invention, a highly reliable semiconductor device, and manufacturing method thereof is provided.

### Industrial Applicability

The present invention is applicable in the manufacturing of electronic devices such as semiconductor devices, etc.

The patent application is based on Japanese Patent Application No. 2001-260181 filed with the Japan Patent Office on August 29, 2001, and including claims, drawings and summary, the entire disclosure of which is hereby incorporated by reference.

## Claims

1. A manufacturing method of a semiconductor device (11) **characterized by** comprising:
a step of forming insulating layers (13, 14) that are structured by silicon as the main component, and comprises a groove (23) at one side, and a hole (21) that penetrates from the bottom part of said groove (23) to the other side;
a barrier layer forming step of exposing the surface of the inner wall of said groove (23) and said hole (21) to the plasma of gas including nitrogen, and forming a barrier layer (25) that is structured by silicon nitride film, on the surface region of the inner wall of the groove (23) and the hole (21);
a step of embedding an interconnection (wiring) layer (24) made of conductive material, to the inner side of the groove (23) and the hole (21) through the barrier layer (25).

2. The manufacturing method of the semiconductor device (11) according to claim 1, **characterized in that** the barrier layer forming step comprises nitriding the surface region of the groove (23) and the hole (21) by exposing the surface of the inner wall of the groove (23) and the hole (21) to the plasma of gas including nitrogen.

3. The manufacturing method of the semiconductor device (11) according to claim 1, **characterized in that** said plasma of gas including nitrogen is generated by irradiating microwave from a plane antenna (111) that comprises a plurality of slits (111a).

4. The manufacturing method of the semiconductor device (11) according to claim 1, **characterized in that** said insulating layers (13, 14) are structured by porous dielectric films.

5. A manufacturing method of a semiconductor device (11) **characterized by** comprising:
a step of forming a first insulating layer (13) structured by silicon as the main component,
a step of exposing the surface of the insulating layer (13) to the plasma of gas including nitrogen, and forming a stopper film (20) that is structured by a silicon nitride film, on the surface region of the first insulating layer (13);
a step of forming a second insulating layer (14) on the stopper film (20);
a step of forming a hole (31) that penetrates the first insulating layer (13) and the second insulating layer (14);
a step of forming a hole or groove (23) that overlaps with said hole (31) in said second insulating layer (14), using said stopper film (20) as an etching stopper.

6. The manufacturing method of the semiconductor device (11) according to claim 5, **characterized in that** the step of forming said stopper film (20) comprises nitriding the surface region of the first insulating layer (13) by exposing the surface of the first insulating layer (13) to the plasma of gas including nitrogen.

7. The manufacturing method of the semiconductor device (11) according to claim 5, **characterized in that** the plasma of gas including nitrogen is generated by irradiating microwave from a plane antenna (111) comprising a plurality of slits (111a) to the gas including nitrogen.

8. The manufacturing method of the semiconductor device (11) according to claim 5, **characterized in that** the first and second insulating layers (13, 14) are structured by porous dielectric films.

9. The manufacturing method of the semiconductor device (11) according to claim 1, **characterized in that** copper is used as the main component, for said conductive material.

10. The manufacturing method of the semiconductor device (11) according to claim 5, **characterized in that** copper is used as the main component, for said conductive material.

11. The manufacturing method of the semiconductor device (11) according to claim 1, **characterized in that** gas including hydrogen is further used as said gas.

12. The manufacturing method of the semiconductor device (11) according to claim 5, **characterized in that** gas including hydrogen is further used as said gas.

13. The manufacturing method of the semiconductor device (11) according to claim 1, **characterized in that** the forming of said barrier layer (25) is carried out at room temperature to 600°C.

14. The manufacturing method of the semiconductor device (11) according to claim 5, **characterized in that** the forming of said barrier layer (25) is carried out at room temperature to 600°C.

15. The manufacturing method of the semiconductor device (11) according to claim 1, **characterized in that** the barrier layer (25) is formed in a thickness of 1nm to 20nm.

16. The manufacturing method of the semiconductor device (11) according to claim 5, characterized un that the barrier layer (25) is formed in a thickness of 1nm to 20nm.

17. The manufacturing method of the semiconductor device (11) according to claim 1, **characterized in that** the stopper film (20) is formed in a thickness of 1nm to 20nm.

18. The manufacturing method of the semiconductor device (11) according to claim 5, **characterized in that** the stopper film (20) is formed in a thickness of 1nm to 20nm.

19. A semiconductor device (11) **characterized by** comprising:
insulating layers (13, 14) that are structured by silicon as the main component, and comprise a groove (23) at one side, and a hole (21) that penetrates from the bottom part of said groove (23) to the other side;
an interconnection layer (24), which is embedded in said groove (23) and said hole (21), and is made of conductive material; and
a barrier layer (25) which comprises a silicon nitride film, and is provided at the interface with the insulating layers (13, 14) and the interconnection layer (24), and which prevents diffusion of said conductive material, to said insulating layers (13, 14).

20. A semiconductor device (11) **characterized by** comprising:
insulating layers (13, 14) that are structured by silicon as the main component, and comprise a groove (23) at one side, and a hole (21) that penetrates from the bottom part of said groove (23) to the other side;
an interconnection layer (24), which is embedded in said groove (23) and said hole (21), and is made of conductive material,
a barrier layer (25) which is provided at the interface with the insulating layers (13, 14) and the interconnection layer (24), and which prevents diffusion of said conductive material, to said insulating layers (13, 14); wherein
said barrier layer (25) is formed by exposing the surface of the insulating layers (13, 14) to the plasma generated by irradiating microwave to gas that includes nitrogen from a plane antenna (111) that comprises a plurality of slits (111a), and forming a silicon nitride film on the surface region of the insulating layers (13, 14).

21. A semiconductor device (11) **characterized by** comprising:
a first insulating layer (13) which comprises a hole (21) and which is structured by silicon as the main component;
a stopper film (20) provided on the first insulating layer (13), and comprises an opening that overlaps with said hole (21);
a second insulating layer (14) which is provided on the stopper film (20), and comprises a hole or groove (23) that overlaps with the opening, and has a larger diameter than said opening; wherein
said stopper film (20) is formed by exposing one surface of the first insulating layer (13) to the plasma of gas including nitrogen, which is generated by irradiating microwave to the gas including nitrogen, from a plane antenna (111) comprising a plurality of slits (111a), and forming a silicon nitride film on the surface region.
